Europäisches Patentamt

European Patent Office

Office européen des brevets

(11) Publication number: **0 104 919**
**B1**

(12) **EUROPEAN PATENT SPECIFICATION**

(45) Date of publication of patent specification: **31.01.90**

(21) Application number: **83305715.1**

(22) Date of filing: **26.09.83**

(51) Int. Cl.⁵: **G 11 C 19/08, G 11 C 13/06**

(54) **Thermomagnetic recording methods.**

(30) Priority: **25.09.82 JP 167321/82**
**31.03.83 JP 55651/83**

(43) Date of publication of application:
**04.04.84 Bulletin 84/14**

(45) Publication of the grant of the patent:
**31.01.90 Bulletin 90/05**

(84) Designated Contracting States:
**DE FR GB NL**

(56) References cited:
**US-A-3 624 622**
**US-A-3 838 450**

(73) Proprietor: **SONY CORPORATION**
**7-35 Kitashinagawa 6-Chome Shinagawa-ku**
**Tokyo 141 (JP)**

(72) Inventor: **Kaneko, Masahiro**
**c/o Sony Corporation 7-35 Kitashinagawa 6-**
**chome**
**Shinagawa-ku Tokyo (JP)**
Inventor: **Tamada, Hitoshi**
**c/o Sony Corporation 7-35 Kitashinagawa 6-**
**chome**
**Shinagawa-ku Tokyo (JP)**
Inventor: **Okamoto, Tsutomu**
**c/o Sony Corporation 7-35 Kitashinagawa 6-**
**chome**
**Shinagawa-ku Tokyo (JP)**
Inventor: **Yamada, Toshiro**
**c/o Sony Corporation 7-35 Kitashinagawa 6-**
**chome**
**Shinagawa-ku Tokyo (JP)**

(74) Representative: **Cotter, Ivan John et al**
**D. YOUNG & CO. 10 Staple Inn**
**London WC1V 7RD (GB)**

Courier Press, Leamington Spa, England.

**Description**

This invention relates to thermomagnetic recording methods. Reference should be made to our earlier European Patent Application Publication EP—A—0 061 892, which also relates to thermomagnetic recording methods.

Conventional thermomagnetic recording methods make use of bit recording methods in which recording is carried out by focussing a laser beam. These bit recording methods include the Curie temperature recording method and the temperature compensation point recording method. With these methods, bits can be formed when the laser beams are incident on a recording medium. However, in view of the various factors acting on the bits, the bits are unstable and recorded bits may disappear if the magnetic wall coercive force is low. Therefore, a high magnetic wall coercive force is required to retain the recorded information bits.

It has also been proposed to form fine bits in an amorphous GdCo thin film. However, bits recorded by this method are reported to be unstable. It has, therefore, been proposed to vary the magnetic characteristics of the amorphous GdCo thin film in the direction of its thickness in order to stabilise the bits. Such techniques are reported in Appl. Phys. Lett. 32(10), pp. 673 to 675. This publication discloses a method of forming a thin film by continuously reducing a sputtering current and a method of forming a two-layer thin film. This publication reports that stable bit information was obtained with films obtained by this method when the temperature and external magnetic field were varied. The publication also reports that the bits were stable even if an external magnetic field of 0 Oe or a relatively intense magnetic field, such as 280 to 350 Oe, was applied to an amorphous GdCo thin film prepared by this method. However, with an amorphous GdCo thin film, stable bit information cannot be held unless the film has a relatively high coercive force. Since the magnetic wall coercive force is relatively high and the film quality is not uniform, the formation of bits of uniform diameter is difficult. In order to form bits of uniform diameter, the output of the laser must be controlled, as a result of which the laser has to have a complex structure.

The publication cited above also reports a case of an amorphous GdCo thin film formed under constant sputtering conditions. With this thin film, either it is impossible to form bits of small diameter or the bits are extremely unstable with changes in the external magnetic field and temperature. Bits were formed by the temperature compensation point recording method in this case. The compensation temperature is only slightly higher than the ambient temperature and is subject to abrupt changes with changes in the vicinity of the ambient temperature. For this reason, temperature control within a limited range is necessary for the purpose of holding the recorded information.

It has also been proposed to record a large quantity of information on a ferromagnetic thin film of MnBi, Ti-substituted MnBi, and EuO by the Curie temperature recording method (IEEE Trans., Magn., Vol. MAG-13, May 1977, pp. 982 to 988; Applied Optics, Vol. 13-4, pp. 770 to 777). According to this proposal, MnBi is most preferable since the recording density is high and the angle of magnetic polarisation is great. However, MnBi has a Curie temperature as high as 360°C and requires more energy for recording. On the other hand, the decomposition temperature is as low as 450°C, providing only a slight difference from the Curie temperature. For this reason, it is difficult to control the output of the laser such that the temperature falls within the range of these two temperatures. Furthermore, an MnBi thin film has low weathering or weather resistance and is easily damaged by a humid atmosphere. MnBi has a coercive force of 1.5 kOe and requires a magnetic field of 700 Oe for erasing the information. Thus, a separate device is required to induce such a high magnetic field for erasing the recorded information. This adversely affects the size of the device.

It has also been proposed (see last mentioned publication) to use an Mn—Cu—Bi alloy having a low Curie temperature of 200°C as a thermomagnetic recording medium (Ibid., IEEE Trans. Magn.). However, an Mn—Cu—Bi alloy has a coercive force as high as 1.5 kOe. Furthermore, with this alloy, the diameter of the bit varies with the output of the laser. In other words, the greater the pulse width of the laser beam, the greater the diameter of the bit. This results in degradation in recording sensitivity and impairs high-density recording.

It has further been proposed to record information at high density and with low power by the compensation temperature recording method using a thin film of $(BiGaLuSm)_3(FeAl)_5O_{12}$ on a GGG (gallium garnet) substrate by the liquid phase epitaxial method (hereinafter referred to as "the LPE method"). This technique was proposed in Transactions of the Japan Society of Applied Magnetics, November 1980, 5aB-3. In this case, the output of the laser is similarly as high as 70 to 100 mW. Furthermore, cylindrical magnetic bubble domains are star-shaped instead of circular, which results in degraded readout sensitivity. The diameter of the bit is greater than is desirable and the coercive force of the thin film is not sufficiently low from a practical point of view.

According to the invention there is provided a thermomagnetic recording method comprising the steps of:

applying a bias magnetic field to a layer of soft magnetic material that has an easy axis of magnetisation normal to the layer, the material being of a type in which magnetic bubble domains can be generated, and the strength of the magnetic field being selected to be between a run-out field and a collapse field; and

applying an optical beam to the layer so as to form a bubble domain having a direction of magnetisation opposite to that of the bias magnetic field, the layer of soft magnetic material having selected values of

$$\frac{\Delta M_s}{\Delta T}/M_s, \quad \frac{\Delta \sigma_w}{\Delta T}/\sigma_w,$$

l, h, $H_c$ and $M_s$ that satisfy the relationship

$$\left\{C_M\left(\frac{\Delta M_s}{\Delta T}\right)/M_s - C_\sigma\left(\frac{\Delta \sigma_w}{\Delta T}\right)/\sigma_w\right\}|\text{grad } T| \cdot d + \frac{8}{\pi} \cdot \frac{H_c}{4\pi M_s} \geq 0$$

where $H_c$ is the coercive force of the layer, $M_s$ is the saturation magnetisation of the layer, h is a thickness of the layer, $\sigma_w$ is the domain wall energy, d is a diameter of the generated domain, and each of $C_M$ and $C_\sigma$ is a constant determined by h, d and l, where

$$l = \frac{\sigma_w}{4\pi M_s^2}.$$

In a thermomagnetic recording method according to one embodiment of the invention:

the layer of soft magnetic material is formed of magnetic garnet containing bismuth and the relationship between the anisotropy magnetic field ($H_k$) and the thickness (h) thereof is such as to fall within a region which, in a coordinate system in which a thickness (h) is indicated on the abscissa thereof in micrometres and the anisotropy magnetic field ($H_k$) is indicated on the ordinate thereof in Oersteds, is defined by connecting a point A (0.5, 0), a point B (0.5, 3000), a point C (1.0, 3000), a point D (1.5, 1800), a point E (3.0, 800), a point F (6.0, 400), a point G (6.0, 0) and the point A sequentially to one another by straight lines; and

the optical beam is applied to the layer from the side of the layer.

In a thermomagnetic recording method according to another embodiment of the invention:

the layer of soft magnetic material is disposed on a transparent substrate;

the layer of soft magnetic material is formed of magnetic garnet containing bismuth and the relationship between the anisotropy magnetic field ($H_k$) and the thickness (h) thereof is such as to fall within a region which, in a coordinate system in which the thickness (h) is indicated on the abscissa thereof in micrometres and the anisotropy magnetic field ($H_k$) is indicated on the ordinate thereof in Oersteds, is defined by connecting a point A' (0.5, 0), a point B' (0.5, 3000), a point C' (1.75, 3000), a point D' (2.0, 1400), a point E' (4.0, 0) and the point A' sequentially to one another by straight lines; and

the optical beam is applied to the layer from the side of the substrate.

Thermomagnetic recording methods embodying the invention and described hereinbelow incorporate the following advantageous features. They use a magnetic recording layer of low coercive force, a recording signal bit is recorded at a desired position on a magnetic recording layer and is held therein stably, a high density recording can be achieved independently of laser power, laser beam diameter or pulse width, and the recorded bits are formed with low power.

The invention will now be further described, by way of illustrative and non-limiting example, with reference to the accompanying drawings, in which like references designate like elements and parts throughout, and in which:

Figure 1 is a schematic cross-sectional diagram of an example of a recording medium that can be used in a thermomagnetic recording method embodying the present invention;

Figure 2 is a diagram showing an example of a system for carrying out the thermomagnetic recording method embodying the present invention;

Figure 3 is a table showing measured results of quality of a thermomagnetic recording and characteristics of the record medium;

Figure 4 is a graph showing a relationship between attractive force for a bit at the centre of a beam spot of recording light and a ratio h/l for each sample medium shown in Figure 3;

Figure 5 is a graph showing a relationship between an attractive force for a bit and the temperature coefficient of a collapse magnetic field;

Figure 6 is a diagram showing an example of a bit recording and observation apparatus;

Figures 7 and 9 are graphs which show a relationship between an anisotropy magnetic field $H_k$ and a film thickness and which indicate recordable and unrecordable regions of bit information; and

Figures 8 and 10 are graphs showing a relationship between the recording power and the anisotropy magnetic field.

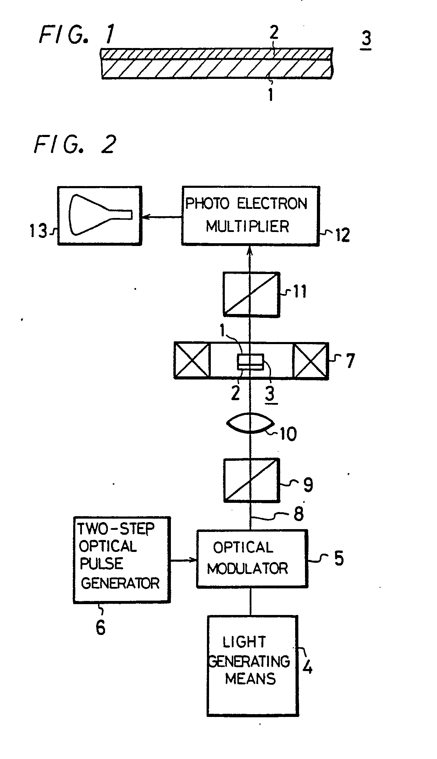

As shown in Figure 1, a magnetic record or recording medium 3 comprises a film or layer 2 epitaxially grown on a crystal substrate 1 which is, for example, of non-magnetic rare-earth gallium garnet such as gadolinium gallium garnet (GGG). The film or layer 2 is made of soft magnetic material, has a strong uniaxial magnetic anistropy normal to the surface of the layer, and has an axis of easy magnetisation normal to the surface of the layer. The layer 2 may, for example, comprise a YSmCaFeGe-system garnet layer such as $(YSmCa)_3(FeGe)_5O_{12}$. A soft characteristic of the soft magnetic material layer 2 having an easy axis of magnetisation normal to the surface of the layer should be selected so as to allow the diameter of a recorded bit to be determined in practice only by a bias magnetic field when the layer is applied to the substrate 1 to form the magnetic record medium 3. It is desirable for the coercive force thereof to be selected to be lower than about 3 Oe and, more preferably still, lower than about 1 Oe.

According to a method embodying the present invention, thermomagnetic recording using the above-described layer 2 of soft magnetic material having an easy axis of magnetisation normal to the layer can be carried out as follows. First, a bias magnetic field of predetermined strength is applied to the layer 2 of soft magnetic material having an easy axis of magnetisation normal to the layer so as to cause the layer to adopt a state in which the whole surface thereof has a single magnetic domain and, also, magnetisation is generated in a direction perpendicular to the surface of the layer. While the layer 2 is in this state, an optical or light beam is focussed on the surface of the layer and the light beam thus absorbed is converted to heat so that the temperature rises locally, thereby to form a magnetic domain of opposite direction to the bias magnetic field. A bit is thus written therein or recorded thereon. The recorded bit is a bubble domain and has a predetermined diameter. Also, the direction of magnetisation is opposite to that of the bias magnetic field.

The strength of the bias magnetic field applied to put the layer of soft magnetic material into the state having a single magnetic domain over the whole visual field may vary in accordance with the nature of the layer of soft magnetic material employed, but it is sufficient that the strength thereof is selected to be in a range between a run-out field (the magnetic bubble domain tends to adopt a linear shape) $H_2$ and a collapse field (no magnetic bubble domain appears) $H_0$. By way of example, in the case of the above-mentioned $(YSmCa)_3(FeGe)_5O_{12}$ LPE (liquid phase epitaxy) layer, the strength of the bias magnetic field is selected to be in a range from 57 Oe to 73 Oe.

A method of applying the bias magnetic field will now be described. Since the coercive force of the layer of soft magnetic material, particularly the magnetic wall coercive force thereof, is small, the selected bias magnetic field to be applied may naturally be small. Thus, a compact-sized bias magnetic field generating apparatus may be sufficient, whereby a solenoid coil, a rubber magnet and so on can be used.

Subsequently, while applying the bias magnetic field to the layer as mentioned before so that the layer of soft magnetic material having an easy axis of magnetisation normal to the layer is placed in the state in which a single magnetic domain is generated over the whole visual field and the direction of the magnetisation is selected to be perpendicular to the layer surface, an optical beam is incident on the layer thereby to form the bubble domain having the predetermined diameter, whereby the bit information is recorded thereon. Since the intensity of the incident light and the pulse width in a recording mode of the optical beam pulse do not affect the diameter of the bit being recorded, these parameters are not necessarily specified. However, the intensity of the incident light of the optical beam pulse may be selected to be in the range of from approximately 1 to about 100 mW, and the pulse width may be selected to be in a range of from approximately 0.1 to about 100 microseconds. Then, if an optical beam having the above incident light intensity and pulse width is introduced into the layer, the form of the recorded bit can be made substantially perfectly cylindrical.

The bit information, once recorded, can be erased by applying to the layer 2 a magnetic field which has a strength greater than the collapse magnetic field $H_0$. And, since the collapse magnetic field $H_0$ of the layer of soft magnetic material, having an easy axis of magnetisation normal to the layer, is quite small, there is then an advantage that the recorded bit information can be erased with ease.

The signal thus recorded can be read out or reproduced by using a magneto-optical effect. An example of a method of reproducing the recorded signal will now be described. Light such as Ar (argon) laser light and so on is polarised by a polariser to become linearly polarised light. The linearly polarised light is passed through a beam splitter and then converged or focussed by an objective lens onto the layer of soft magnetic material in which the recorded signal is written. The converged light beam is supplied through the layer to an analyser or reflected by a reflective film or layer deposited on the layer of soft magnetic material, refracted perpendicularly by the beam splitter and then supplied to the analyser. During the above operation, the linearly polarised light beam is subjected to Faraday rotation in a clockwise or anticlockwise direction in response to the magnetisation direction of the magnetic bubble domains existing in the layer of soft magnetic material. Thus, the light beam derived from an output side of the analyser is modulated in pulse width in response to the distance between the bits. The modulated light signal thus obtained is supplied to a photo-electric conversion device, such as a photodiode and so on, converted to an electrical signal, and supplied to (for example) a frequency modulated (FM) reproducing apparatus and reproduced. Reproduction is also possible according to a method involving coding at equal intervals.

As set forth above, with this thermomagnetic recording method embodying the present invention the temperature of the layer of soft magnetic material is raised by irradiation by an optical beam pulse and a magnetic bubble domain having a direction opposite to the bias magnetic field is formed in the layer of the demagnetising field. Further, in order to effect a more stable recording, a layer of soft magnetic material having an easy axis of magnetisation normal to the surface of the layer is selected. When information bits are formed by heat generated by optical pulses as described above, the heating due to the irradiating light

4

beam causes a temperature gradient in which the temperature is a maximum at the centre of the beam and becomes gradually lower as the periphery of the optical beam is approached. In this case, since the magnetic characteristic of the layer has temperature dependency, the magnetic characteristic has a gradient corresponding to the temperature gradient. Thus, the recorded bit receives the following force:

$$\frac{8}{\pi} \cdot \frac{H_c}{4\pi M_s} + \frac{|2vd|}{\mu_w \cdot 4\pi M_s} = C_M \frac{\Delta M_s}{M_s} - C_\sigma \frac{\Delta \sigma_w}{\sigma_w} \qquad (1)$$

(see Bell System Technical Journal, Vol. 50, page 711, 1971), where $H_c$ is the coercive force, $\mu_w$ is the mobility of the magnetic domain wall, vd is the velocity of movement of the bit, $M_s$ is the saturation magnetisation, $\sigma_w$ is the magnetic domain energy, $\Delta M_s$ and $\Delta \sigma_w$ are difference values between the saturation magnetisation $M_s$ and the magnetic domain wall energy $\sigma_w$ at respective ends of the bit diameter, and $C_M$ and $C_\sigma$ are positive constants which are determined by a film thickness h, a bit diameter d and a characteristic length $l = \sigma_w/4\pi M_s^2$. The direction of the force which the bit recieves is the direction along which the saturation magnetisation $M_s$ becomes large while the magnetic domain wall energy $\sigma_w$ becomes small. If the temperature coefficients of the saturation magnetisation $M_s$ and the magnetic domain wall energy, $\sigma_w$ are negative, the bit is moved to the low temperature side by the first term in the right hand side of Equation (1) and is moved to the high temperature side by the second term in Equation (1). As a result, when the value of the first term on the right hand side of Equation (1) is larger than that of the second term in the right hand side, the bit is moved to the low temperature side so that the recorded bit is moved towards a position which is displaced from the centre of the recording beam spot, namely, a diverging direction, thus making it impossible to control the final position of the bit being recorded. Consequently, a material having such characteristics is undesirable for use as the film or layer 2 of the thermomagnetic recording material. Therefore, the thermomagnetic recording material is selected such that the value of the second term of the right hand side of Equation (1) is larger than that of the first term of the right hand side thereof so that the bit is moved to the centre of the beam spot. The condition under which the recorded bit can be prevented from being displaced from the centre of the writing or recording light beam is expressed by the following equation in consideration of the coercive force $H_c$ thereof.

$$\{C_M(\frac{\Delta M_s}{\Delta T})/M_s - C_\sigma(\frac{\Delta \sigma_w}{\Delta T})/\sigma_w\}|\text{grad } T|d + \frac{8}{\pi} \cdot \frac{H_c}{4\pi M_s} \geqslant 0 \qquad (2)$$

The material used for the layer of soft magnetic material having an easy axis of magnetisation normal to the surface of the layer to be used as the record medium in a recording method embodying the present invention is thus selected to be of such a nature that it can satisfy Equation (2). Thus, photomagnetic recording can be carried out stably by the heat generated in the layer. That is, a material in which the condition expressed by the Equation (2) is satisfied is chosen by selecting

$$(\frac{\Delta M_s}{\Delta T})/M_s, \quad (\frac{\Delta \sigma_w}{\Delta T})/\sigma_w,$$

the characteristic length l, the thickness h, the coercive force $H_c$ and the saturation magnetisation $M_s$.

It is desirable for the thermomagnetic recording method embodying the invention to have particularly high recording sensitivity or to have a reduced requirement for recording power. When, in the above-described thermomagnetic recording method, the magnetised layer is formed of a garnet layer such as magnetic garnet containing bismuth Bi, $(TmBi)_3(FeGa)_5O_{12}$, $(TmBiSm)_3(FeGa)_5O_{12}$ or $(LuBiSm)_3(FeGa)_5O_{12}$, it has been found that the recording power can be lowered when a relationship between the anisotropy magnetic field $H_k$ and the film thickness h thereof is specified.

In the magnetised layer, the relationship between the anisotropy magnetic field $H_k$ and the film thickness h thereof may be selected in such a manner that a coordinate point (x, y) representing the relationship, in a coordinate system in which the film thickness h is indicated on the abscissa thereof and the anisotropy magnetic field $H_k$ is indicated on the ordinate thereof, falls within a region or range formed by connecting a point A (0.5, 0), a point B (0.5, 3000), a point C (1.0, 3000), a point D (1.5, 1800), a point E (3.0, 800), a point F (6.0, 400), a point G (6.0, 0) and the point A sequentially to one another by straight lines, the thermomagnetic recording being carried out by irradiating the layer with the optical beam from the side of the layer of soft magnetic material.

Also, in the magnetised layer formed on the gadolinium gallium garnet (GGG) substrate, the relationship between the anisotropy magnetic field $H_k$ and the film thickness h may be selected in such a manner that a coordinate point (x, y) represents the relationship, in a coordinate system in which the film thickness h is indicated on the abscissa thereof and the anisotropy magnetic field $H_k$ is indicated on the ordinate thereof, falls within a region or range formed by connecting a point A' (0.5, 0), a point B' (0.5, 3000), a point C' (1.75, 3000), a point D' (2.0, 1400), a point E' (4.0, 0) and the point A' sequentially to one another by straight lines, the thermomagnetic recording being carried out by irradiating the optical beam on the layer through the GGG substrate.

Practical examples of embodiment of the present invention will now be described.

## Example 1

As shown in Figure 1, a film or layer 2 of soft magnetic material, having an easy axis of magnetisation normal to the surface of the layer and made of $(Gd, Sm, Lu)_3(Fe, Al)_5O_{12}$, was formed on a GGG substrate 1 according to a liquid phase epitaxial growth technique to provide a record medium 3. The substrate 1 had a thickness of 500 microns and the thickness h of the film or layer 2 was 5.8 microns. The recording and readout on or from the record medium 3 was performed by a recording and reproducing apparatus shown in Figure 2, which includes a light generating means or source 4 such as an Ar (argon) laser having wavelength of 488 nm and so on. The light from the source 4, namely argon laser light, is introduced into an optical modulator 5 from which an optical pulse or beam modulated in response to the information to be recorded is derived. A two-step optical pulse generator 6 is connected to the optical modulator 5.

In order to apply the bias magnetic field $H_b$ to the record medium 3 from the outside thereof in the direction of its thickness, there is provided, for example, an electromagnet or coil 7. Pulsed light 8 modulated by the optical modulator 5 is linearly polarised by a polariser 9 and then focussed on the layer 2 of the record medium 3 by a convergent lens 10. Thus, in response to the modulated laser beam light, a desired item of information is recorded on the layer 2 of the record medium 3 as a cylindrical magnetic domain (bubble domain). In order to read out the information recorded on the record medium 3, the laser light from, for example, the laser beam generating means 4 is passed through the record medium 3 by way of the polariser 9. In this event, the plane of polarisation of the linearly polarised light passed through the polariser 9 is rotated by the bit recorded on the layer 2 of the record medium 3, namely the bubble domain, and then delivered therefrom. The light derived from the record medium 3 is supplied through an analyser 11 to a photo detecting means, for example a photo electron multiplier 12. The output therefrom is introduced into an observing means, for example an oscilloscope 13, which enables the information bit on the record medium 3 to be observed. As mentioned before, the record medium 3 is supplied with the bias magnetic field generated, for example, by the bias magnetic field generating coil 7 surrounding the record medium 3, during and after the recording mode without fail so that the recorded bubble domain is maintained in its recorded state. The record medium 3 in Example 1 is taken as a sample number 1 and recording for various other materials (sample numbers 2 to 12) was performed by the apparatus shown in Figure 2. The quality of the recording, the film thickness h, the characteristic length l and the respective temperature characteristics, namely, each value of

$$\alpha^M = (\frac{\Delta M_s}{\Delta T})/M_s, \quad \alpha^\sigma = (\frac{\Delta \sigma_w}{\Delta T})/\sigma_w$$

and

$$\alpha^{H_b} = (\frac{\Delta H_o}{\Delta T})/H_o$$

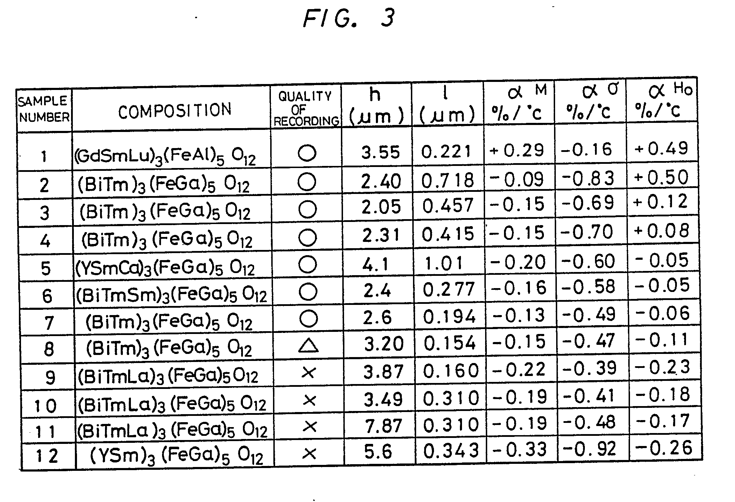

are indicated in the table shown in Figure 3.

In that column of the table of Figure 3 indicating the quality of the recording, the symbol O indicates cases in which a bubble domain is locally caused on the portion irradiated by the light beam, the symbol X indicates cases in which reversed magnetisation occurs in portions except the portion irradiated by the light beam or no reversed magnetisation occurs at all, and the symbol $\Delta$ indicates a state in which a bubble domain sometimes occurs in the portion irradiated by the light beam or in another portion than the portion irradiated by the light beam.

The record media 3 having different compositions of the layer 2 are taken as sample numbers 1 to 12, respectively, and shown in the table of Figure 3. The compositions in these samples 1 to 12 are properly selected, respectively.

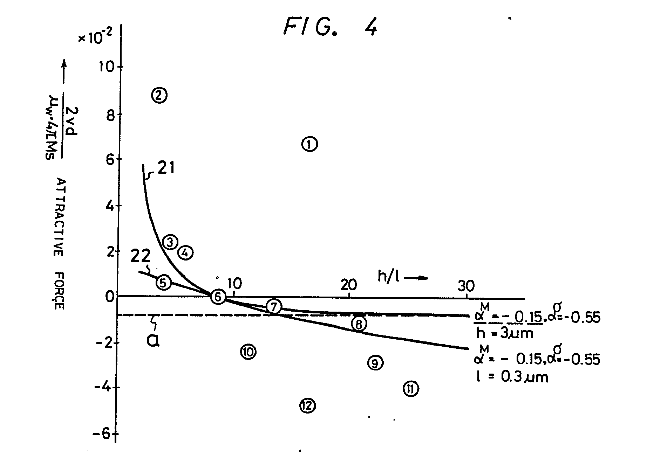

Figure 4 is a graph in which the attractive force calculated by Equation (2) above, namely the force

$$\frac{2 \, vd}{\mu_w \cdot 4\pi M_s}$$

by which the bit is attracted to the high temperature side at the centre of the radiated beam, is plotted against the function or ratio h/l. In the graph of Figure 4, reference numerals ① to ⑫ are respectively plots of examples of the samples 1 to 12 having the characteristics shown in Figure 3. The origin 0 of the attractive force corresponds to the coercive force $H_c=0$. In Equation (2), $|grad \, T|=10$ deg/micron and the bit diameter d is selected as a square root mean value, $d=\sqrt{d_0 d_2}$ between the bit diameter $d_0$ in the collapse magnetic field $H_0$ and the bit diameter $d_2$ in the run-out magnetic field $H_2$. In the graph of Figure 4, a curve 21 indicates a case in which $\alpha^M=-0.15$, $\alpha^\sigma=-0.55$ and $h=3$ microns, while a curve 22 similarly indicates a

case in which $\alpha^M=-0.15$, $\alpha^6=-0.55$ and $l=0.3$ microns. From the graph of Figure 4, it can be seen that the attractive forces of the samples 1 to 6 are in the positive range and coincide well with the measured results of recording quality shown in the table of Figure 3 wherein recording was carried out satisfactorily. Moreover, regarding the sample 7, when considering its coercive force $H_c$ its origin is displaced to the position shown by a reference letter $a$ in the graph of Figure 4 ($H_c=1$ Oe and $M_s=25$ emu/cm$^3$) and, although its attractive force is not in the positive range, the bit belongs to the region not movable from the portion irradiated by the light beam. This fact confirms that the recording on the sample 7 was satisfactory. The reason for this may be that the coercive force $H_c$ of the sample 7 is approximately 0.5 Oe. In other words, according to the graph of Figure 4, when Equation (2) was satisfied in consideration of the coercive force $H_c$, from the experimental results. It was confirmed that excellent recording was carried out, or the bit can be formed stably by a cylindrical magnetic domain. The record medium having the sample number 8 is slightly displaced from the region which allows stable recording (hereinbelow referred to as the stable recording region). The sample 8 permits recording in practice, but the bit being recorded is sometimes displaced from the radiation position of the light beam. This coincides with the fact that the sample 8 is disposed on the border of the stable recording region. From the graph of Figure 4, it can be understood that the sample media having the sample numbers 9 to 12 are positioned far away from the stable recording region. With regard to the sample 9, the recording bit was always generated at a position distant from the radiation position of the light beam. With regard to the sample media 10 to 12, no recording was carried out at all. As a result, it was confirmed that whether stable recording at the centre of the light beam spot is possible or not depends on whether Equation (2) above can be satisfied.

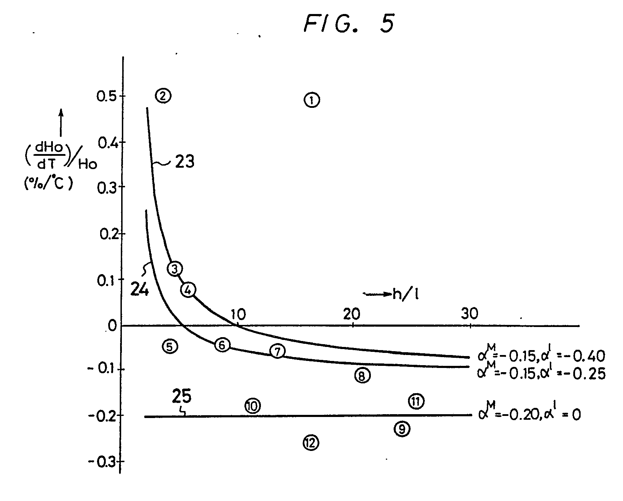

The sample media having the sample numbers 10 to 12 revealed that, if the condition is considerably displaced from the stable recording region of Equation (2), even recording was impossible. The reason for this will now be considered. Figure 5 is a graph in which, instead of the attractive forces as in the graph of Figure 4, the temperature coefficient

$$\alpha^{H_0}=\frac{\Delta H_0}{\Delta T}/H_0$$

of the collapse magnetic field $H_0$ is plotted against the function $h/l$. In the graph of Figure 5, a solid line curve 23 is a measured curve wherein $\alpha^M=-0.15$ and $\alpha^l=-0.40$, a solid line curve 24 is a like measured curve wherein $\alpha^M=-0.15$ and $\alpha^l=-0.25$, and a straight line 25 is a like measured curve wherein $\alpha^M=-0.20$ and $\alpha^l=0$. The above measurement was carried out on the basis of the fact that, when

$$\alpha^l=(\frac{\Delta l}{\Delta T})/l=\alpha^\sigma-2\alpha^M,$$

the collapse magnetic field $H_0$ is given by the relationship

$$H_0=4\pi M_s\left[1+\frac{3l}{4h}-(\frac{3l}{h})^{1/2}\right] \tag{3}$$

(see "Magnetic Bubble" page 28, issued by Maruzen Co., Ltd. in 1977).

From the graphs of Figures 4 and 5, it can be seen that while the attractive force and the temperature coefficient of the collapse magnetic field have different dependencies on $\alpha^M$, $\alpha^\sigma$, $h$ and $l$, regarding the characteristic which allows the region apart from the stable recording region, the temperature coefficient of the collapse magnetic field has a significant trend towards taking a large negative value. Also, the fact that the $\alpha^{H_0}$ is selected to have a large negative value means that, even when the value to which the temperature is raised by the recording light beam is not very large, the collapse magnetic field $H_0(T)$ in the region in which the temperature was raised becomes smaller than the bias magnetic field. This fact means that the bit cannot be generated. Thus, when the recording region is greatly displaced from the stable recording region, the value of $\alpha^{H_0}$ becomes large and negative so that recording in this recording region is impossible with the material characteristics in that region.

Example 2

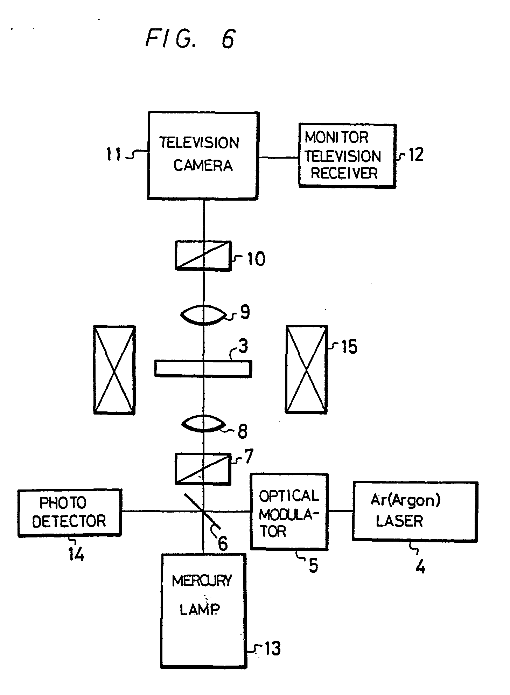

As shown in Figure 1, layers 2 of soft magnetic material having an easy axis of magnetisation normal to the surface of the layer 2 and made of $(TmBi)_3(FeGa)_5O_{12}$, $(TmBiSm)_3(FeGa)_5O_{12}$ and $(LuBiSm)_3(FeGa)_5O_{12}$ were formed on a GGG substrate 1 of 500 microns thickness according to a liquid phase epitaxial growth technique to form a plurality of record media 3. Bit recording was carried out on the record media 3 and the bits thus formed were observed. According to a bit recording and observing apparatus used in this case, as shown in Figure 6, laser light emitted from an Ar (argon) laser 4 is passed through an optical modulator 5 and thereby converted into the form of a pulsed light beam having a pulse width of 5.0 microseconds. The pulsed light beam is passed through a half mirror 6, a polariser 7 and a convergent lens 8 and then focussed on the magnetised layer 2 of the record medium 3 as a beam spot having a diameter of 1.0 microns. The intensity of the incident light beam on the record medium 3 was measured by a photo detector 14 and corrected. Then, whether or not the bit was formed or recorded on the magnetized layer 2 as described above was investigated as follows. Light from a mercury lamp 13 was irradiated through the half mirror 6, the polariser 7 and the convergent lens 8 onto the magnetised layer 2. After passing through the record medium 3, the light was focussed through an objective lens 9 and an analyser 10 onto a television camera 11, which was observed by a monitor television receiver 12.

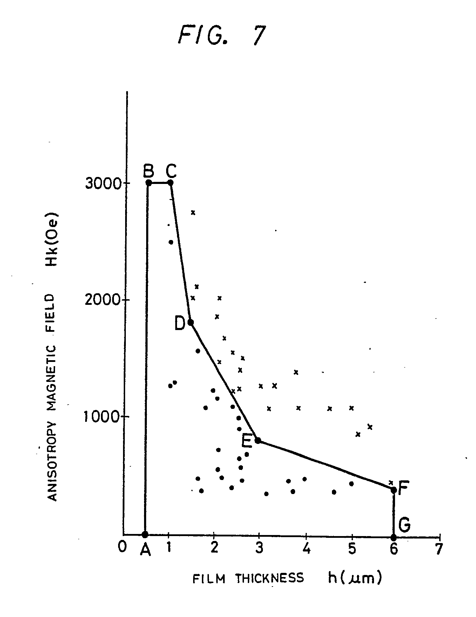

Reference numeral 15 designates a bias magnetic field generating means by means of which the magnetised layer 2 of the record medium 3 is subjected to a magnetic field of 1/2 $(H_0+H_2)$, where $H_0$ is its collapse magnetic field and $H_2$ is its run-out magnetic field. With regard to the relationship between the anisotropy magnetic field $H_k$ and the film thickness h in each of the record media 3, the two cases in which bit recording was possible or impossible under the condition that the intensity of the laser light was selected to be lower than 10 mW are shown by symbols ● and x, respectively, on the graph of Figure 7. Consequently, in bit recording employing an Ar laser beam having a beam spot diameter of 1.0 microns and a pulse width of 5.0 microseconds, the values of the anisotropy magnetic field $H_k$ and the film thickness h of the magnetized film or layer 2 which allow recording with a recording power of lower than 10 mW lie within a region or range which is such that, in the coordinate system shown in Figure 7, in which the film thickness h is indicated on the abscissa thereof in micrometers and the anisotropy magnetic field $H_k$ is indicated on the ordinate thereof in Oersteds, the region is defined by connecting a point A (0.5, 0), a point B (0.5, 3000), a point C (1.0, 3000), a point D (1.5, 1800), a point E (3.0, 800), a point F (6.0, 400), a point G (6.0, 0) and the point A sequentially to one another by straight lines.

Thus, the relationship between the anisotropy magnetic field $H_k$ and the film thickness h is selected so as to fall within the region which is formed by connecting the points A, B, C, D, E, F and A by straight lines.

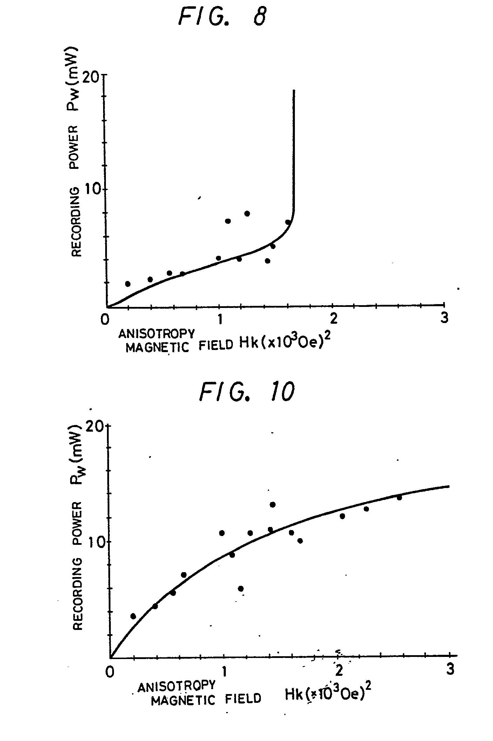

Furthermore, in Example 2, the recording power Pw of the recording laser light for the anisotropy magnetic field $H_k$ which allows the formation of a bit was measured for a record medium having a thickness h of 2.3±0.2 microns. The measured results are shown in the graph of Figure 8.

Example 3

Record media 3 were formed according to the same method as that of Example 2. In this case, the recording laser light was radiated onto the magnetised layer 2 of each record medium 3 from the side of the substrate 1.

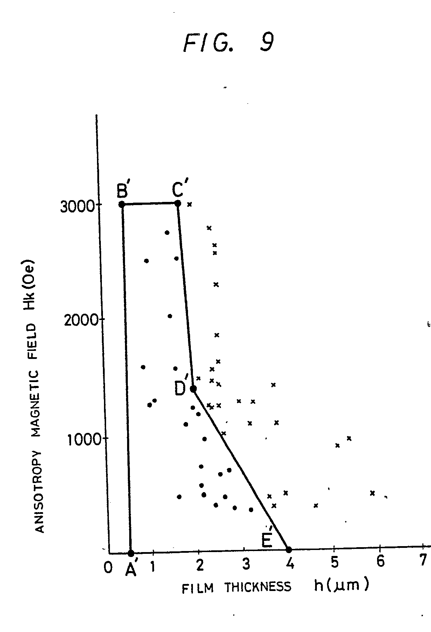

In association with the relationship between the anisotropy magnetic field $H_k$ and the film thickness h of each record medium 3 in that case, the results in which bit recording was or was not possible with laser light having a recording power of 10 mW are indicated, respectively, by symbols ● and x in the graph of Figure 9. Thus, in bit recording employing the Ar laser beam having a beam spot diameter of 1.0 microns and a pulse width of 5.0 microseconds, the anisotropy magnetic field $H_k$ and the film thickness h of the magnetised layer 2 which allow recording with a recording power of lower than 10 mW lie within a region or range which, in the coordinate system as shown in Figure 9 in which the film thickness h is indicated on the abscissa thereof in micrometres and the anisotropy magnetic field $H_k$ on the ordinate thereof in Oersteds, is defined by joining a point A' (0.5, 0), a point B' (0.5, 3000), a point C' (1.75, 3000), a point D' (2.0, 1400), a point E' (4.0, 0) and the point A' sequentially to one another by straight lines.

Thus, when the record medium 3 is irradiated with recording laser light from the side of the substrate 1, the relationship between the anisotropy magnetic field $H_k$ and the film thickness h is selected so as to fall within the region which is formed by connecting the points A', B', C', D' and A' to one another by straight lines.

Furthermore, in Example 3, the power Pw of the recording laser light for the anisotropy magnetic field $H_k$ which allows the formation of a bit was measured for a record medium 3 having a thickness h of 2.3±0.2 microns. The measured results are shown in the graph of Figure 10.

The reason why the recording power according to Example 3 is higher than that of Example 2 may be explained as follows. When the magnetised layer 2 of the record medium 3 is irradiated with recording laser light from the side of the substrate 1, the magnetised film 2 is greatly heated at its position adjacent to the substrate 1 with the result that the heat is radiated through the substrate 1.

Even when the magnetised layer 2 of the record medium 3 is irradiated with the laser light from the side of the substrate 1, the substrate 1 has a high transmissivity to the Ar laser light so that the influence of the film thickness of the substrate 1 is negligible.

Thermomagnetic recording methods embodying the present invention have the following advantages.

It suffices for the layer of soft magnetic material having an easy axis of magnetisation normal to the surface of the layer used in the present invention to have a magnetic wall coercive force selected to have a certain constant value, for example lower than 2 to 3 Oe. Further, the layer can be used even if its crystallinity is not uniform. Thus, manufacture of the layer of soft magnetic material having an easy axis of magnetisation normal to the surface of the layer can be carried out more easily than in the prior art. As described above, the magnetic wall coercive force is small so that the recorded bit information can be erased by using a small magnetic field, thus bringing about a practical advantage.

Since the form of the recorded bit is substantially perfectly cylindrical, there is an advantage that the bit information can be read out with excellent readout sensitivity.

Further, the diameter of the bit being recorded is not dependent on the output power of the input laser light, but can easily be controlled by changing the bias magnetic field, which feature is quite advantageous. Accordingly, correction of the diameter of the bit after it has been recorded, which was impossible due to the large coercive force in the prior art, becomes possible, leading to a significant advantage in practice.

Moreover, since the layer of soft magnetic material having an easy axis of magnetisation normal to the surface of the layer has no critical temperature such as a temperature compensation point near room temperature and, also, its Curie temperature is, for example, around approximately 200°C, the layer can stably maintain the information against changes of temperature over a wide range.

Furthermore, since the characteristics of the layer of soft magnetic material having an easy axis of magnetisation normal to the surface of the layer are specified, the recording bit can stably be recorded at the centre of the spot of recording light with low power and, accordingly, recording can be carried out with high resolution, high sensitivity and high density.

In addition, when a magnetic garnet film containing bismuth (Bi) is used as the layer of soft magnetic material, recording can be carried out reliably with low recording power by specifying the relationship between the anisotropy magnetic field $H_k$ and the film thickness h of the magnetised layer, resulting in a large benefit in practice.

## Claims

1. A thermomagnetic recording method comprising the steps of:

applying a bias magnetic field to a layer (2) of soft magnetic material that has an easy axis of magnetisation normal to the layer, the material being of a type in which magnetic bubble domains can be generated, and the strength of the magnetic field being selected to be between a run-out field and a collapse field; and

applying an optical beam to the layer (2) so as to form a bubble domain having a direction of magnetisation opposite to that of the bias magnetic field, the layer of soft magnetic material having selected values of

$$\frac{\Delta M_s}{\Delta T}/M_s, \quad \frac{\Delta \sigma_w}{\Delta T}/\sigma_w,$$

l, h, $H_c$ and $M_s$ that satisfy the relationship

$$\{C_M(\frac{\Delta M_s}{\Delta T})/M_s - C_\sigma(\frac{\Delta \sigma_w}{\Delta T})/\sigma_w\}|grad\ T| \cdot d + \frac{8}{\pi} \cdot \frac{H_c}{4\pi M_s} \geqslant 0$$

where $H_c$ is the coercive force of the layer (2), $M_s$ is the saturation magnetisation of the layer (2), h is a thickness of the layer (2), $\sigma_w$ is the domain wall energy, d is a diameter of the generated domain, and each of $C_M$ and $C_\sigma$ is a constant determined by h, d and l, where

$$l = \frac{\sigma_w}{4\pi M_s^2}$$

2. A thermomagnetic recording method according to claim 1, wherein:

the layer (2) of soft magnetic material is formed of magnetic garnet containing bismuth and the relationship between the anisotropy magnetic field ($H_k$) and the thickness (h) thereof is such as to fall within a region which, in a coordinate system in which the thickness (h) is indicated on the abscissa thereof in micrometres and the anisotropy magnetic field ($H_k$) is indicated on the ordinate thereof in Oersteds, is defined by connecting a point A (0.5, 0), a point B (0.5, 3000), a point C (1.0, 3000), a point D (1.5, 1800), a point E (3.0, 800), a point F (6.0, 400), a point G (6.0, 0) and the point A sequentially to one another by straight lines; and

the optical beam is applied to the layer (2) from the side of the layer.

3. A thermomagnetic recording method according to claim 1, wherein:

the layer (2) of soft magnetic material is disposed on a transparent substrate (1);

the layer (2) of soft magnetic material is formed of magnetic garnet containing bismuth and the relationship between the anisotropy magnetic field ($H_k$) and the thickness (h) thereof is such as to fall within a region which, in a coordinate system in which the thickness (h) is indicated on the abscissa thereof in micrometres and the anisotropy magnetic field ($H_k$) is indicated on the ordinate thereof in Oersteds, is defined by connecting a point A' (0.5, 0), a point B' (0.5, 3000), a point C' (1.75, 3000), a point D' (2.0, 1400), a point E' (4.0, 0) and the point A' sequentially to one another by straight lines; and

the optical beam is applied to the layer (2) from the side of the substrate (1).

# EP 0 104 919 B1

**Patentansprüche**

1. Thermomagnetisches Aufnahmeverfahren mit den Schritten

eines Anlegens eines vormagnetisierenden magnetischen Feldes an eine Schicht (2) aus weichmagnetischem Material, das eine zur Schicht normale Achse leichter Magnetisierung aufweist, wobei das Material eines Typs ist, bei welchem magnetische Blasendomänen erzeugt werden können und die Stärke des magnetischen Feldes so gewählt ist, daß es zwischen einem Auslauffeld und einem Zusammenbruchfeld ist, und

eines Anwendens eines optischen Strahls auf die Schicht (2), um eine Blasendomäne mit einer Magnetisierungsrichtung zu bilden, die zu der des vormagnetisierenden magnetischen Feldes entgegengesetzt ist, wobei die Schicht aus weichem magnetischem Material ausgewählte Werte von

$$\frac{\Delta M_s}{\Delta T}/M_s, \quad \frac{\Delta \sigma_w}{\Delta T}/\sigma_w,$$

l, h, $H_c$ und $M_s$ hat, welche der Beziehung

$$\{C_M(\frac{\Delta M_s}{\Delta T})/M_s - C_\sigma(\frac{\Delta \sigma_w}{\Delta T})/\sigma_w\}|grad \cdot T| \cdot d + \frac{8}{\pi} \cdot \frac{H_c}{4\pi M_s} \geq 0$$

genügt, wobei $H_c$ die Koerzitivkraft der Schicht (2), $M_s$ die Sättigungsmagnetisierung der Schicht (2), h eine Dicke der Schicht (2), $\sigma_w$ die Domänenwandenergie, d ein Durchmesser der erzeugten Domäne und $C_M$ und $C_\sigma$ jeweils eine durch h, d und l bestimmte Konstante, bedeuten, wobei

$$l = \frac{\sigma_w}{4\pi M_s^2}$$

gilt.

2. Thermomagnetisches Aufnahmeverfahren nach Anspruch 1, wobei

die Schicht (2) aus weichmagnetischem Material aus magnetischem Wismuth enthaltendem Granat gebildet ist und die Beziehung zwischen dem anisotropen magnetischen Feld ($H_k$) und der Dicke (h) der Schicht (2) derart ist, daß sie in einen Bereich fällt, der in einem Koordinatensystem, in welchem die Dicke (h) auf der Abszisse in Mikrometer und das anisotrope magnetische Feld ($H_k$) auf der Ordinate in Oersted aufgetragen ist, durch aufeinanderfolgendes Miteinanderverbinden eines Punktes A (0,5, 0), eines Punktes B (0,5, 3000), eines Punktes C (1,0, 3000), eines Punktes D (1,5, 1800), eines Punktes E (3,0, 800), eines Punktes F (6,0, 400), eines Punktes (6,0, 0) und des Punktes A durch gerade Linien definiert ist, und wobei der optische Strahl auf die Schicht (2) von der Seite der Schicht angewendet ist.

3. Thermomagnetisches Aufnahmeverfahren nach Anspruch 1, wobei

die Schicht (2) aus weichmagnetischem Material auf einem transparenten Substrat (1) angeordnet ist,

die Schicht (2) aus weichmagnetischem Material aus magnetischem Wismuth enthaltendem Granat gebildet ist und die Beziehung zwischem dem anisotropen magnetischen Feld ($H_k$) und der Dicke (h) der Schicht (2) derart ist, daß sie in einen Bereich fällt, der in einem Koordinatensystem, in welchem die Dicke (h) auf der Abszisse in Mikrometern und das anisotrope magnetische Feld ($H_k$) auf der Ordinate in Oersted aufgetragen ist, durch aufeinanderfolgendes Miteinanderverbinden eines Punktes A' (0,5, 0), eines Punktes B' (0,5, 3000), eines Punktes C' (1,75, 3000), eines Punktes D' (2,0, 1400), eines Punktes E' (4,0, 0) und des Punktes A' durch gerade Linien definiert ist, und wobei der optische Strahl auf die Schicht (2) von der Seite des Substrats (1) angewendet ist.

**Revendications**

1. Procédé d'enregistrement thermomagnétique, comprenant les opérations suivantes:

appliquer un champ magnétique de polarisation à une couche (2) de matériau magnétique doux qui possède un axe d'aimantation facile perpendiculaire à la couche, le matériau étant d'un type dans lequel des domaines de bulles magnétiques peuvent être produits, et l'intensité du champ magnétique étant sélectionnée de façon à se trouver entre un champ d'excentricité et un champ d'affaissement; et

appliquer à la couche (2) un faisceau optique de manière à former un domaine de bulle possédant un sens d'aimantation qui est opposé à celui du champ magnétique de polarisation, la couche de matériau magnétique doux possédant des valeurs sélectionnées de:

$$\frac{\Delta M_s}{\Delta T}/M_s, \quad \frac{\Delta \sigma_w}{\Delta T}/\sigma_w,$$

l, h, $H_c$ et $M_s$ qui satisfont la relation:

$$\{C_M(\frac{\Delta M_s}{\Delta T})/M_s - C_\sigma(\frac{\Delta\sigma_w}{\Delta T})/\sigma_w\}|\text{grad } T| \cdot d + \frac{8}{\pi} \cdot \frac{H_c}{4\pi M_s} \geqslant 0,$$

où $H_c$ est la force coercitive de la couche (2), $M_s$ est l'aimantation de saturation de la couche (2), $h$ est l'épaisseur de la couche (2), $\sigma_w$ est l'énergie de paroi du domaine, $d$ est le diamètre du domaine créé, et chacun des coefficients $C_M$ et $C_\sigma$ est une constant déterminée par $h$, $d$ et $l$, où

$$l = \frac{\sigma_w}{4\pi M_s^2}$$

2. Procédé d'enregistrement thermomagnétique selon la revendication 1, où:
la couche (2) de matériau magnétique doux est formée de grenat magnétique contenant du bismuth et la relation entre le champ magnétique d'anisotropie ($H_k$) et son épaisseur (h) est telle qu'elle se trouve à l'intérieur d'une région qui, dans un système de coordonnées dans lequel l'épaisseur (h) est indiquée sur son abscisse, en micromètres, et le champ magnétique d'anisotropie ($H_k$) est indiqué sur son ordonnée, en oersteds, est définie par connexion du point A (0,5; 0), du point B (0,5; 3000), du point C (1,0; 3000), du point D (1,5; 1800), du point E (3,0, 800), du point F (6,0; 400), du point G (6,0; 0) et du point A à l'aide de lignes droites les reliant l'un à l'autre successivement; et
le faisceau optique est appliqué à la couche (2) depuis le côté de la couche.

3. Procédé d'enregistrement thermomagnétique selon la revendication 1, où:
la couche (2) de matériau magnétique doux est disposée sur un substrat transparent (1);
la couche (2) de matériau magnétique doux est formée de grenat magnétique contenant du bismuth et la relation entre le champ magnétique d'anisotropie ($H_k$) et son épaisseur (h) est telle qu'elle se trouve à l'intérieur d'une région qui, dans un système de coordonnées dans lequel l'épaisseur (h) est indiquée sur son abscisse, en micromètres, et le champ magnétique d'anisotropie ($H_k$) est indiqué sur son ordonnée, en oersteds, est définie par connexion du point A' (0,5; 0), du point B' (0,5; 3000), du point C' (1,75; 3000), du point D' (2,0; 1400), du point E' (4,0; 0) et du point A' à l'aide de lignes droites les reliant l'un à l'autre successivement; et
le faisceau optique est appliqué à la couche (2) depuis le côté du substrat (1).

FIG. 1

FIG. 2

## FIG. 3

| SAMPLE NUMBER | COMPOSITION | QUALITY OF RECORDING | h (μm) | l (μm) | $\alpha$ M %/°c | $\alpha$ σ %/°c | $\alpha$ Ho %/°c |
|---|---|---|---|---|---|---|---|
| 1 | $(GdSmLu)_3(FeAl)_5O_{12}$ | ◯ | 3.55 | 0.221 | +0.29 | −0.16 | +0.49 |
| 2 | $(BiTm)_3(FeGa)_5O_{12}$ | ◯ | 2.40 | 0.718 | −0.09 | −0.83 | +0.50 |
| 3 | $(BiTm)_3(FeGa)_5O_{12}$ | ◯ | 2.05 | 0.457 | −0.15 | −0.69 | +0.12 |
| 4 | $(BiTm)_3(FeGa)_5O_{12}$ | ◯ | 2.31 | 0.415 | −0.15 | −0.70 | +0.08 |
| 5 | $(YSmCa)_3(FeGa)_5O_{12}$ | ◯ | 4.1 | 1.01 | −0.20 | −0.60 | −0.05 |
| 6 | $(BiTmSm)_3(FeGa)_5O_{12}$ | ◯ | 2.4 | 0.277 | −0.16 | −0.58 | −0.05 |
| 7 | $(BiTm)_3(FeGa)_5O_{12}$ | ◯ | 2.6 | 0.194 | −0.13 | −0.49 | −0.06 |
| 8 | $(BiTm)_3(FeGa)_5O_{12}$ | △ | 3.20 | 0.154 | −0.15 | −0.47 | −0.11 |
| 9 | $(BiTmLa)_3(FeGa)_5O_{12}$ | × | 3.87 | 0.160 | −0.22 | −0.39 | −0.23 |
| 10 | $(BiTmLa)_3(FeGa)_5O_{12}$ | × | 3.49 | 0.310 | −0.19 | −0.41 | −0.18 |
| 11 | $(BiTmLa)_3(FeGa)_5O_{12}$ | × | 7.87 | 0.310 | −0.19 | −0.48 | −0.17 |
| 12 | $(YSm)_3(FeGa)_5O_{12}$ | × | 5.6 | 0.343 | −0.33 | −0.92 | −0.26 |

FIG. 4

FIG. 5

FIG. 6

5

## FIG. 7

## FIG. 8

## FIG. 10

## FIG. 9